# EUROPEAN PATENT SPECIFICATION

(11) **EP 2 006 863 B1**
(45) Date of publication and mention of the grant of the patent: **11.01.2012**
(21) Application number: 07714615.7
(22) Date of filing: 20.02.2007
(51) Int. Cl.: H01L 39/24, B32B 15/01, C22C 9/00, C22C 9/02

(54) **PRECURSOR FOR MANUFACTURE OF Nb3Sn SUPERCONDUCTING WIRE ROD, AND Nb3Sn SUPERCONDUCTING WIRE ROD**
PRECURSOR ZUR HERSTELLUNG EINES SUPRALEITENDEN NB3SN-DRAHTSTABS UND SUPRALEITENDER NB3SN-DRAHTSTAB
PRECURSEUR DE FABRICATION DE TIGE DE FIL DE SUPERCONDUCTION Nb3Sn ET CETTE MEME TIGE

(30) Priority: 23.02.2006 JP 2006046742
(43) Date of publication of application: 24.12.2008
(73) Proprietor: Kabushiki Kaisha Kobe Seiko Sho, Chuo-ku Kobe-shi Hyogo 651-8585 (JP); Japan Superconductor Technology, Inc., Kobe-shi Hyogo 6512271 (JP)
(72) Inventor: MIYAZAKI, Takayoshi, Kobe-shi, Hyogo 651-2271 (JP); MURAKAMI, Yukinobu, Kobe-shi, Hyogo 651-2271 (JP)
(74) Representative: Müller-Boré & Partner Patentanwälte
(86) International application number: PCT/JP2007/053115
(87) International publication number: WO 2007/099820

(56) References cited:
- FR-A1- 2 873 488
- GB-A- 2 003 766
- JP-A- 03 071 517
- JP-A- 08 287 752
- JP-A- 09 245 539
- JP-A- 2002 117 734
- US-A1- 2006 032 042

## Description

### TECHNICAL FIELD

The present invention relates to an Nb₃Sn superconducting wire rod to be manufactured by a bronze process or an internal diffusion method and to a precursor for manufacturing such an Nb₃Sn superconducting wire rod (precursor for the manufacturing a superconducting wire rod). In particular, the invention relates to a technology for manufacturing an Nb₃Sn superconducting wire rod which is useful as a raw material of a superconducting magnet for the generation of a high magnetic field.

### BACKGROUND ART

Among the fields where a superconducting wire rod is put into practical use, with regard to a superconducting magnet for use in a high resolution nuclear magnetic resonance (NMR) analyzer, as the generated magnetic field becomes higher, the resolution is more increased. Therefore, in recent years, there is a tendency that the high magnetic field superconducting magnet is requested more and more. Also, with regard to a magnet for use in a nuclear fusion reactor, when the generated magnetic field is high, energy capable of achieving plasma confinement becomes large. Therefore, there is a tendency that the high magnetic field superconducting magnet for use in a nuclear fusion reactor is also requested more and more.

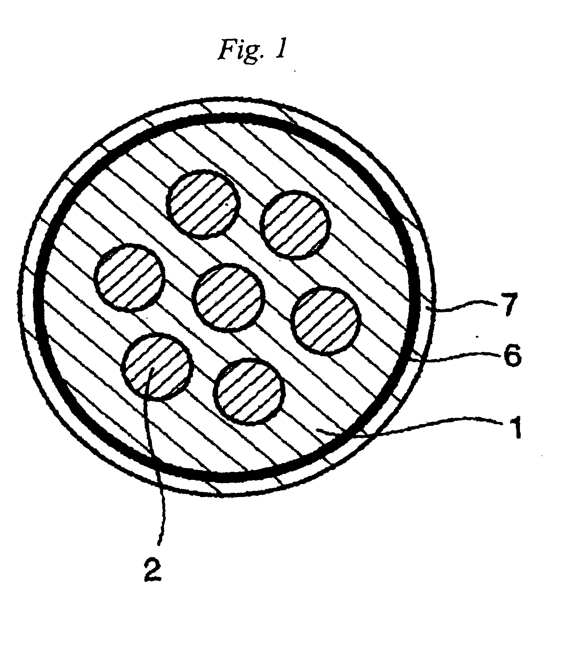

As a superconducting wire rod which is used for such a superconducting magnet for the generation of a high magnetic field, an Nb₃Sn wire rod is put into practical use, and a bronze process is mainly used for manufacturing this Nb₃Sn superconducting wire rod. According to this bronze process, as illustrated in Fig. 1 (schematic view of a precursor for manufacturing an Nb₃Sn superconducting wire rod), a plural number (seven in the drawing) of core materials 2 composed of Nb or an Nb-based alloy are embedded in a Cu-Sn-based alloy (bronze) matrix 1 to constitute a composite wire rod. By subjecting this composite material to wire drawing, the core materials 2 are made thin to form a filament (hereinafter referred to as "Nb-based filament"); a plural number of composite wire rods composed of this Nb-based filament and bronze are bundled to form a wire rod group; and copper (stabilization copper layer 7) is disposed on the outer periphery thereof for the purpose of stabilization, followed by wire drawing.

Also, in the foregoing precursor, as illustrated in Fig. 1, a constitution in which a diffusion barrier layer 6 is disposed between a portion where the plurality of Nb-based filaments are disposed in the Cu-Sn-based alloy (bronze) matrix 1 (this portion will be hereinafter sometimes referred to as "superconducting core part") and the stabilization copper layer 7 located in the outside thereof is general. This diffusion barrier layer 6 is composed of, for example, an Nb layer, a Ta layer or two layers of an Nb layer and a Ta layer (see, for example, Patent Document 1), prevents the diffusion of Sn in the superconducting matrix part into the outside during a diffusion heat treatment from occurring and exhibits an action for suppressing the diffusion of Sn into the stabilization copper.

By subjecting the foregoing precursor (wire rod group after the wire drawing) to a diffusion heat treatment (Nb₃Sn forming heat treatment) at about 600 °C to 800 °C, it is possible to form an Nb₃Sn compound layer at the interface between the Nb-based filament and the bronze matrix. While seven Nb-based filaments are illustrated in Fig. 1 for convenience sake of the description, in fact, it is general to dispose from several hundred to several ten thousand filaments.

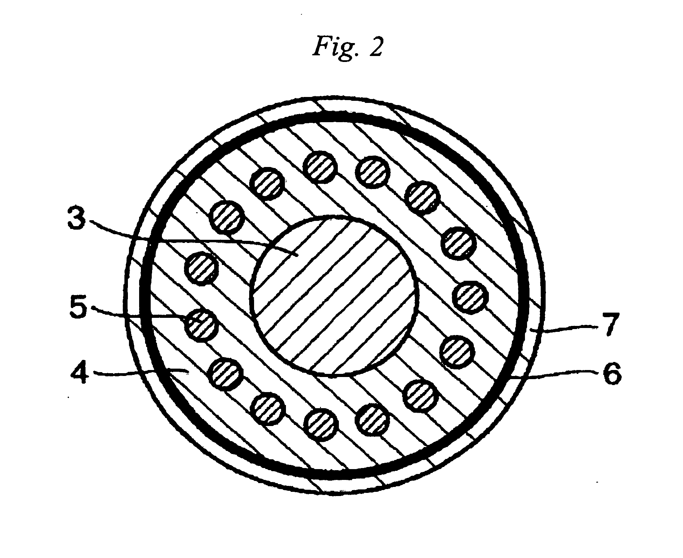

As a method for manufacturing an Nb₃Sn superconducting wire rod, in addition to the foregoing bronze process, an internal diffusion process is also known. According to this internal diffusion process (also referred to as "internal Sn process"), as illustrated in Fig. 2 (schematic view of a precursor for manufacturing an Nb₃Sn superconducting wire rod), not only a core 3 composed of Sn or an Sn-based alloy (hereinafter sometimes generally referred to as "Sn-based metal core") is embedded in the center of Cu or Cu-based alloy 4 (hereinafter sometimes referred to as "Cu based material"), but a plurality of Nb or Nb-based alloy cores 5 (hereinafter sometimes generally referred to as "Nb-based metal core") are disposed in the Cu based material 4 in the surroundings of the Sn-based metal core 3 such that they do not come into contact with each other, thereby forming a precursor (precursor for manufacturing a superconducting wire rod).

The internal diffusion process is concerned with a method in which after subjecting this precursor to cross section reduction processing such as wire drawing, Sn in the Sn-based metal core 3 is diffused by a diffusion heat treatment (Nb₃Sn forming heat treatment) and allowed to react with an Nb-based metal core 5 to form Nb₃Sn (see, for example, Patent Document 2).

Also, in the foregoing precursor, as illustrated in Fig. 2, a constitution in which a diffusion barrier layer 6 is disposed between a portion where the foregoing Nb-based metal core 5 and Sn-based metal core 3 are disposed (this portion will be hereinafter sometimes referred to as "superconducting core part") and a stabilization copper layer 7 located in the outside thereof is also employed. The constitution of this diffusion barrier layer 6 is the same as that in the case of the precursor as illustrated in Fig. 1.

The manufacture of the precursor for manufacturing a superconducting wire rod as illustrated in Fig. 2 is carried out in the following procedures. First of all, an Nb-based metal core (Nb-based filament) is inserted in a Cu matrix tube, and they are subjected to cross section reduction processing such as extrusion and wire drawing to form a composite rod (usually, a rod having a hexagonal cross-sectional shape), which is then cut in an appropriate length. Then, the foregoing composite rod is filled in a billet having a external cylinder made of Cu and provided with a diffusion barrier layer, a Cu rod is disposed at the center thereof and subjected to extrusion processing, and the Cu part at the center is then mechanically perforated to constitute a pipe-shaped composite rod. Alternatively, as another method, a plural number of the foregoing composite rods are filled in a hollow billet constituted of a Cu external cylinder and a Cu internal cylinder and having the diffusion barrier layer 6 (between the external cylinder and the internal cylinder), followed by pipe extrusion to configure a pipe-shaped composite rod.

Then, the Sn-based metal core 3 is inserted in a central hole of the pipe-shaped composite rod thus prepared by such a method, followed by diameter reduction processing to manufacture the precursor as illustrated in Fig. 2.

While the precursor as illustrated in Fig. 2 is constituted using a single Sn metal core 3 and a plurality of Nb-based metal cores 5, it is also possible to constitute the precursor using a plurality of Sn-based metal cores 3. Also, as to the Nb-based metal core 5, in fact, it is general to dispose from several hundred to several thousand metal cores.

Also, in case of manufacturing the precursor for manufacturing a superconducting wire rod as illustrated in Fig. 1, the manufacture is basically carried out in the same procedures, except for using a Cu-Sn matrix tube in place of the Cu matrix tube and disposing no Sn-based metal core at the center.
Patent Document 1: JP-A-60-253114, claims and the like
Patent Document 2: JP-A-49-114389, claims and the like

### DISCLOSURE OF THE INVENTION

Also, as illustrated in Figs. 1 and 2, each of the foregoing precursors is constituted to dispose the diffusion barrier layer between the superconducting matrix part and the stabilization copper as an external part thereof. However, there may be a possibility of the generation of problems to be caused due to the diffusion barrier layer, such as deterioration in workability at wire drawing and lowering in superconducting property.

Now, a phenomenon for lowering the properties in a superconducting wire rod includes "coupling". This phenomenon is a phenomenon in which when a varying magnetic field is applied to the superconducting wire rod from outside, for example, a current is induced in the superconducting core part between the Nb-based filaments each other or between the Nb-based filament and the diffusion barrier layer and bears as if it were electromagnetically integrated. When such a phenomenon is caused, the effective filament diameter increases, and when the current or magnetic field varies in the superconducting wire rod, a loss of energy (hereinafter referred to as "alternating current loss" or "AC loss") becomes large.

In order to reduce such an AC loss, it is necessary to use a raw material which does not form an Nb₃Sn phase in the portion of the diffusion barrier layer. As the raw material of the diffusion barrier layer, Nb or Ta is used as described previously. Of these, when Ta is used, since an Nb₃Sn phase is not formed, the AC loss is suppressed. However, the workability is poor so that breakage or the like is easy to occur. Also, in case of using Nb as the raw material, although the workability is excellent as compared with Ta, an Nb₃Sn phase is formed in the diffusion barrier layer, and the foregoing coupling is easy to occur.

In view of the foregoing matters, a composite layer composed of two layers of an Nb layer and a Ta layer is also proposed (see the foregoing Patent Document 1). However, when Ta with poor workability is used, breakage is easy to occur at the time of wire drawing. Also, since Nb and Ta have a high melting point and hardly form a metal bond, they have a drawback in mutual adhesion and become difficult in uniform working. When the working is nonuniform, breakage of the diffusion barrier layer is caused, and a situation in which a residual resistivity ratio in the superconducting wire rod is ultimately lowered is caused. In the worst case, there is a possibility that breakage occurs on the way of wire drawing.

In the case where only Ta is used as the raw material of the diffusion barrier layer, not only the workability becomes extremely worse, but the cost is high as compared with Nb, resulting in an increase in costs. Also, since an Nb₃Sn phase is not formed in the Ta portion, coupling is hardly caused. However, since Ta does not contribute to the formation of an Nb₃Sn phase, a non-superconducting portion increases, whereby a critical current density Jc tends to be rather lowered.

Under these circumstances, the invention has been made. An object of the invention is to provide a constitution capable of cheaply realizing a precursor for manufacturing an Nb₃Sn superconducting wire rod which is excellent in workability at the time of cross section reduction processing, devises to reduce an AC loss to be caused due to coupling by making the cross-sectional constitution appropriate and is able to exhibit a excellent superconducting properties; and an Nb₃Sn superconducting wire rod using such a precursor.

The precursor for manufacturing an Nb₃Sn superconducting wire rod which is used in manufacturing an Nb₃Sn superconducting wire rod, the precursor including:
a superconducting core part including Cu or a Cu-based alloy, a single or a plurality of Nb-based filaments composed of Nb or an Nb-based alloy and a single or a plurality of Sn or Sn-based alloy cores, the single or plurality of Nb-based filaments and the single or plurality of Sn or Sn-based alloy cores being disposed in Cu or the Cu-based alloy;
a diffusion barrier layer which is composed of Nb and is disposed on an outer periphery of the superconducting core part; and
a stabilization copper layer,
in which a distance between an inner peripheral surface of the diffusion barrier layer and the Nb-based filament present at an outermost layer part of the superconducting core part is set up at 2 µm or more in a final shape after cross section reduction processing.

This precursor is applied to a bronze process. Also, in the precursor of such a constitution, the distance between the inner peripheral surface of the diffusion barrier layer and the Nb-based filament present at the outermost layer part of the superconducting core part is preferably 10 µm or less.

On the other hand, the foregoing object can also be achieved by employing the following constitution. That is, another constitution of a precursor for manufacturing an Nb₃Sn superconducting wire rod which is used in manufacturing an Nb₃Sn superconducting wire rod, the precursor including:
a superconducting core part including Cu or a Cu-based alloy, a single or a plurality of Nb-based filaments composed of Nb or an Nb-based alloy and a single or a plurality of Sn or Sn-based alloy cores, the single or plurality of Nb-based filaments and the single or plurality of Sn or Sn-based alloy cores being disposed in Cu or the Cu-based alloy;
a diffusion barrier layer which is composed of Nb and is disposed on an outer periphery of the superconducting core part; and
a stabilization copper layer,
in which a distance between an inner peripheral surface of the diffusion barrier layer and the Nb-based filament present at an outermost layer part of the superconducting core part is set up at 2 µm or more in a final shape after cross section reduction processing.

This precursor is applied to an internal diffusion process. Also, in the precursor of such a constitution, the distance between the inner peripheral surface of the diffusion barrier layer and the Nb-based filament present at the outermost layer part of the superconducting core part is preferably 40 µm or less.

In the precursor for manufacturing a superconducting wire rod of the invention, examples of specific means for regulating the distance between the inner peripheral surface of the diffusion barrier layer and the Nb-based filament present in the outermost layer part of the superconducting core part at 2 µm or more include the following constitutions (1) and (2).
(1) A constitution in which the foregoing distance is regulated at 2 µm or more by forming a layer composed of Cu or a Cu-based alloy on an entire surface of the inner periphery of the diffusion barrier layer.
(2) Another constitution in which the foregoing distance is regulated at 2 µm or more by partially forming a layer composed of Ta, Cu or a Cu-based alloy at a position on the inner peripheral surface of the diffusion barrier layer where the Nb-based filament is adjacent to the diffusion barrier layer (the Nb-based filament is disposed closer (but does not contact)).

By heat treating the foregoing precursor for manufacturing a superconducting wire rod, it is possible to manufacture an Nb₃Sn superconductive wire rod exhibiting desired properties.

According to the invention, by regulating the distance between the inner peripheral surface of the diffusion barrier layer and the Nb-based filament present at the outermost layer part of the superconducting core part at 2 µm or more, the constitution of a precursor for manufacturing an Nb₃Sn superconducting wire rod which devises to reduce an AC loss to be caused due to coupling and is able to exhibit excellent superconducting properties has been able to be realized. Also, as specific means for regulating the foregoing distance at 2 µm or more, by basically not using Ta or disposing Ta only in a necessary place, excellent workability can be realized while devising to reduce costs.

### BRIEF DESCRIPTION OF THE DRAWINGS

Fig. 1 is a cross-sectional view schematically illustrating a constitution example of a precursor for manufacturing a superconducting wire rod to be applied to a bronze process.
Fig. 2 is a cross-sectional view schematically illustrating a constitution example of a precursor for manufacturing a superconducting wire rod to be applied to an internal diffusion process.
Fig. 3 is a cross-sectional view illustrating the principal part of the precursor of the invention.
Fig. 4 is a cross-sectional view of the principal part illustrating a specific constitution example of the precursor of the invention.
Fig. 5 is a cross-sectional view of the principal part illustrating another specific constitution example of the precursor of the invention.

### Description of Reference Numerals and Signs

1: Cu-Sn-based alloy matrix
2: Nb-based metal core material
3: Sn-based metal core
4: Cu-based alloy (Cu based material)
5: Nb-based alloy core
6 and 6a: Diffusion barrier layer
7: Stabilization copper layer
10: Matrix
11: Nb-based filament
12: Layer composed of Cu or a Cu-based alloy
15: Superconducting core part

### BEST MODE FOR CARRYING OUT THE INVENTION

In order to achieve the foregoing object, the present inventors have made investigations from various angles. As a result, it has been found that it is possible to realize a precursor from which an Nb₃Sn superconducting wire rod capable of devising to reduce an AC loss to be caused due to coupling and exhibiting excellent superconducting properties can be obtained by optimizing a distance between the inner peripheral surface of the diffusion barrier layer and the Nb-based filament present in the outermost layer part of the superconducting core part, leading to accomplishment of the invention. The constitution of the precursor of the invention is hereunder described with reference to the accompanying drawings.

In this specification, all percentages and the like defined in terms of mass are the same as those defined in terms of weight.

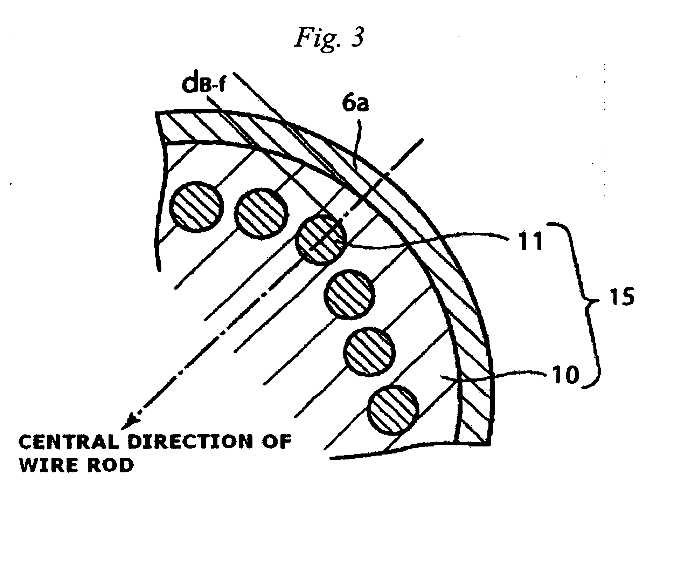

Fig. 3 is a cross-sectional view illustrating the principal part of the precursor of the invention. In the drawing, 6a stands for a diffusion barrier layer which is composed of Nb; 10 stands for a matrix; 11 stands for an Nb-based filament; and 15 stands for a superconducting core part, respectively. In the precursor of the invention, a distance dB-f (distance in a final shape after surface reduction processing) between the inner peripheral cross section of the diffusion barrier layer 6a and the Nb-based filament 11 present at the outermost layer part of the superconducting core part 15 is set up at 2 µm or more. It is not the case that all the Nb-based filaments 11 present in the outermost layer part of the superconducting core' part 15 are present at a uniform distance. The foregoing distance dB-f means a distance between the Nb-based filament present at the most adjacent position to the diffusion barrier layer 6a among the Nb-based filaments 11 present at the outermost layer part and the diffusion barrier layer 6a. (The term "most adjacent" refers to the state that the Nb-based filament 11 is present at the most adjacent position but does not contact). By optimizing the distance dB-f in this way, it is possible to reduce an AC loss to be caused due to coupling.

When this distance dB-f is too large, it is expected that a non-superconducting portion region in the superconducting core part 15 becomes large, whereby the critical current density is lowered. Therefore, it is also preferable to appropriately set up upper limit thereof. Although the upper limit of this distance dB-f varies depending upon a process to be applied, the distance dB-f is preferably 10 µm or less in the precursor to be applied to the bronze process.

On the other hand, in the precursor to be applied to the internal diffusion process, as compared with the bronze method, since there is no limit in the Sn solid solubility amount, the reaction amount can be made large. Therefore, it is possible to make the critical current density Jc higher for that than that in the case by the bronze process. When an absolute value of the critical current density Jc is noted, in case of the internal diffusion process, a allowable range is larger than that in the bronze process, and the distance dB-f can be made large for that. From these viewpoints, in the precursor to be applied to the internal diffusion process, the distance dB-f is preferably 40 µm or less.

Means for regulating the distance dB-f at 2 µm or more in the precursor of the invention are described. In the manufacturing step of the precursor, there may be the case where an Nb-based alloy core is not inserted in a Cu-Sn matrix tube (or a Cu matrix tube), but a wire rod having been subjected to wire drawing (solid material) is used as a spacer, and it may be also considered to dispose such a spacer on the side of the inner peripheral surface of the diffusion barrier layer. In case of using such a spacer in the bronze process, the distance dB-f becomes rather large, whereby the critical current density Jc is lowered (see Test No. 13 in Table 1 as described later). Also, in the internal diffusion process, it is possible to regulate the distance dB-f at 40 µm or less using such a spacer. However, in that case, the interface increases, and the workability is deteriorated.

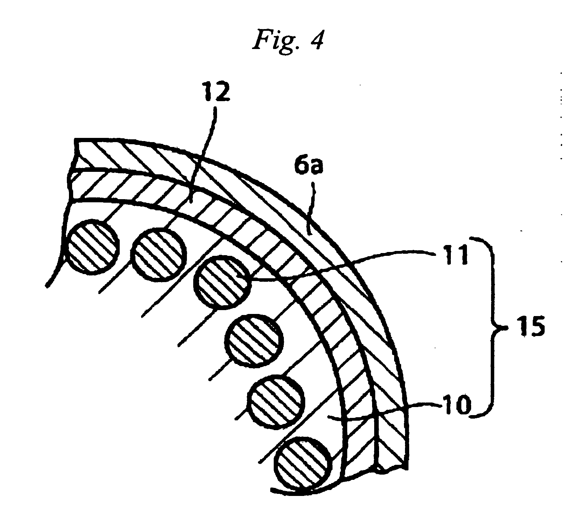

In view of the foregoing matters, in the precursor of the invention, the following constitution can be proposed as specific means for setting up the distance dB-f at an appropriate range. Fig. 4 is a cross-sectional view of the principal part illustrating a specific constitution example of the precursor of the invention. In this constitution, the distance dB-f is regulated at 2 µm or more by forming a layer 12 which is composed of Cu or a Cu-based alloy on the entire surface of the inner peripheral surface of the diffusion barrier layer 6a. By providing this layer 12, even when the raw material of the diffusion barrier layer 6a is Nb, the excellent workability can be maintained.

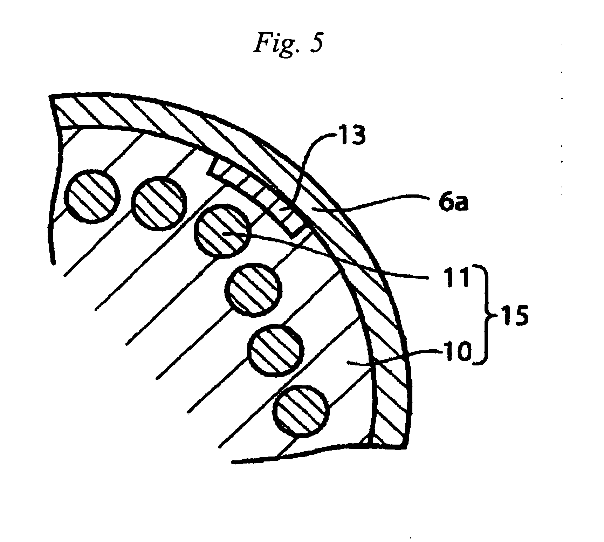

Fig. 5 is a cross-sectional view of the principal part illustrating other specific constitution example of the precursor of the invention. In this constitution, a layer 13 which is composed of Ta or Cu is partially formed only on the inner peripheral surface corresponding to the Nb-based filament 11 disposed most adjacent of the Nb-based filaments 11 present at the outermost layer part on the inner peripheral surface of the diffusion barrier layer 6a. In such a constitution, since the layer 13 is not formed over the entire surface not only in the case where Cu is used as the raw material but in the case where Ta is used as the raw material, the excellent workability can be maintained. The layer 13 may be disposed in a single place or may be disposed in plural places. As to a region where the layer 13 is not provided among the inner peripheral surface of the diffusion barrier layer 6a, it is possible to set up the distance dB-f at a prescribed range by adjusting a bronze ratio of a single core or primary multicore. As the Cu alloy which is used in the foregoing layer 12 or 13, those containing up to about 10% by mass of Sn, etc. can also be used in view of the workability.

In employing any constitution, Ta which is expensive is not used, or even when Ta is used, a constitution in which Ta is not used over the entire surface can be employed. Therefore, it is possible to reduce costs. A combination of a Cu layer and partial Ta can also be used over the entire surface.

In the precursor of the invention, it is also preferable that the diameter of the Nb-based filament is set up at an appropriate size. From such a viewpoint, the diameter of the Nb-based filament is preferably about 1.5 to 6.0 µm in a final shape after cross section reduction processing (namely, a shape prior to the diffusion heat treatment). In high deformation such that the diameter of the Nb-based filament is less than 1.5 µm, since the fluctuation of the diameter in the longitudinal direction of the wire rod is large (sausaging), uniform working cannot be achieved. Also, when this diameter exceeds 6.0 µm, a high critical current density is hardly obtainable. Also, when a reduction of the AC loss is concerned, the diameter of the Nb-based filament is desirably 4 µm or less; and when the strain resistance is concerned, the diameter of the Nb-based filament is desirably 1.5 µm or more.

In the precursor of the invention, it is also preferable to appropriately control a copper ratio (a ratio in cross-sectional area of Cu part to non-Cu part). From the viewpoint of stability, it is desirable that this copper ratio is preferably 0.2 or more, and more preferably 0.8 or more. However, when the copper ratio is too large, the non-superconductive portion increases, whereby the critical current density Jc per the whole cross sections of the wire rod is lowered. Therefore, it is desirable that the copper ratio is preferably 2.0 or less, and more preferably 1.0 or less.

The Cu-Sn alloy which is used in the precursor to be applied in the bronze process is preferably one having an Sn content of 13 to 17% by mass. By making the Sn content fall within this range, the critical current density Jc can be further improved. When this Sn content is less than 13% by mass, an effect for increasing the Sn concentration cannot be exhibited, whereas when it exceeds 17% by mass, a large amount of the Cu-Sn compound is deposited, whereby uniform working of the wire rod is hardly achieved.

On the other hand, in the precursor which is used in the internal diffusion method, as to the basic constitution thereof, the Nb-based metal core 5 (Nb or Nb-based alloy core) and the Sn-based metal core 3 (Sn or Sn-based alloy core) are mutually disposed at intervals in the Cu or Cu-based alloy. As the Cu alloy which is used in such a constitution, one containing an element such as Nb and Ni (about 5 % by mass) in Cu can be used. Also, as the raw material which is used as the Sn-based metal core 3, one containing an element such as Ti, Ta, Zr and Hf in an amount such that the workability is not hindered (about 5 % or less by mass) can be used.

Also, in any of these processes, there may be the case where an Nb-based filament is used (the core material in Fig. 1 and the Nb-based metal core 5 in Fig. 2). As the Nb-based alloy to be used herein, one containing an additive element such as Ta, Hf, Zr and Ti in an amount of about 10 % or less by mass can be used.

In the method of the invention, the foregoing precursor is configured and subjected to annealing and wire drawing, followed by applying a diffusion heat treatment (Nb₃Sn forming heat treatment; usually at 600 °C or higher and not higher than 750 °C) to form an Nb₃Sn based superconducting phase. There can be thus obtained a superconducting wire rod exhibiting excellent properties.

The invention is more specifically described below with reference to the following Examples, but it should not be construed that the invention is limited thereto. As a matter of course, it is possible to carry out the invention by properly applying modifications within the scope adaptive with the gist described previously or later, and all of them are included in the technical scope of the invention.

### Examples

### Example 1 (Bronze process)

An Nb rod having a diameter of 60 mm was inserted in a Cu-(15.5 mass % Sn) alloy having an outer diameter of 65 mm and an inner diameter of 35 mm, and ends were sealed by electron beam welding to prepare an extrusion billet. This extrusion billet was subjected to wire drawing while properly annealing at 500 to 600 °C for one hour on the way, thereby forming a Cu-Sn/Nb composite rod having a hexagonal cross-sectional shape (opposite side of the hexagon: 2.0 mm). This Cu-Sn/Nb composite rod was bundled in the number of 1,369; a Cu sheet having a thickness of 0.1 mm was wound around the outer periphery of the bundle in the number of turns of 5 as shown in the following Table 1; an Nb sheet having a thickness of 0.2 mm (diffusion barrier layer) was wound around the outer periphery in the number of 5 turns; and Cu (stabilization copper layer) having an outer diameter of 120 mm and an inner diameter of 87 mm was disposed in the surroundings thereof. Ends of thus obtained composite wire rod were sealed by electron beam welding to form an extrusion billet (multicore type billet).

The obtained extrusion billet was extruded and subjected to wire drawing to form a wire rod (precursor for manufacturing a superconducting wire rod) having a wire diameter of 0.5 mm. At that time, the wire rod was subjected to twisting so as to have a pitch of 13 mm.

Also, an extrusion billet prepared by winding a 0.2mm Cu sheet in the number of 5 turns to adjust the distance dB-f was prepared.

Also, for comparison, (1) one using an extrusion billet prepared by disposing a Cu-Sn solid material (not having an Nb rod inserted therein) having a hexagonal cross-sectional shape (opposite side of the hexagon: 2.0 mm) on the outer periphery of the foregoing Cu-Sn/Nb composite rod and not winding a Cu sheet but disposing Cu (stabilization copper layer) having an outer diameter of 120 mm and an inner diameter of 87 mm in the surroundings thereof at the time of assembling (Test No. 13 in Table 1); and (2) one using an extrusion billet prepared by winding a Ta sheet having a thickness of 0.2 mm in the number of turns of 5 instead of winding a Cu sheet and disposing Cu (stabilization copper layer) having an outer diameter of 120 mm and an inner diameter of 87 mm in the surroundings thereof (Test No. 14 in Table 1); and the like were prepared.

As to the obtained precursors for the manufacturing a superconducting wire rod (ones having an outer diameter of 0.5 mm), the distance dB-f between the outermost layer filament and the diffusion barrier layer and the number of breakages at the time of extrusion and wire drawing were examined. Also, when each of the precursors was subjected to a heat treatment (diffusion heat treatment) at 650 °C for 150 hours to form an Nb₃Sn superconducting wire rod, the AC loss and the critical current density (Jc) were measured under the following conditions.

### Measurement of distance dB-f between the outermost layer filament and the diffusion barrier layer

The polishing surface of the precursor prior to the heat treatment was subjected to vertical embedding and polishing, and the cross section was observed by an electron microscope, thereby measuring the distance dB-f.

### Measurement of AC loss

The measurement was carried out in a vibrating magnetic field of ±3 T (tesla) in liquid helium (temperature: 4.2 K) by a pick-up coil method.

### Measurement of critical current density Jc

A current was passed through the sample (superconducting wire rod) in an external magnetic field of 12 T (tesla) in liquid helium (temperature: 4.2 K); a generated voltage was measured by a four-probe method; a current value (critical current Ic) at which an electric field where this value was 0.1 µV/cm was measured; and this current value was divided by a cross-sectional area per the non-Cu part of the wire rod to determine the critical current density Jc.

These results are summarized and shown in the following Table 1. As is clear from these results, it is noted that in the samples in which the foregoing distance dB-f was made appropriate by mediating the Cu sheet (Test Nos. 3 to 12), the AC loss is reduced, and a excellent critical current density Jc can be realized. Although Test No. 14 is concerned with one in which Ta is used as the diffusion barrier layer, breakage frequently occurred at the time of wire drawing so that it was impossible to achieve wire drawing to a final wire diameter (diameter: 0.5 mm)

**Table 1**

| Test No. | Number of turns of Cu sheet Cu sheet (time) | Number of breakages (time) | Distance dB-f (µm) | AC loss AC loss (kJ/m³) | Critical current density Jc (A/mm²) |
|---|---|---|---|---|---|
| 1 | 0 | 5 | 1.5 | 1500 | 795 |
| 2 | 1 | 1 | 1.8 | 1200 | 785 |
| 3 | 2 | 0 | 2.2 | 750 | 780 |
| 4 | 3 | 0 | 2.8 | 680 | 778 |
| 5 | 4 | 0 | 3.0 | 650 | 770 |
| 6 | 5 | 0 | 3.5 | 630 | 768 |
| 7 | 6 | 0 | 3.9 | 635 | 771 |
| 8 | 7 | 0 | 4.5 | 627 | 771 |
| 9 | 8 | 0 | 4.9 | 610 | 768 |
| 10 | 9 | 0 | 5.5 | 602 | 770 |
| 11 | 10 | 0 | 6.0 | 597 | 765 |
| 12 | 5 (thickness: 0.2 mm) | 0 | 9.5 | 498 | 745 |
| 13 | Hexagonal spacer | 1 | 13.0 | 530 | 680 |
| 14 | Ta | 16 | Wire drawing impossible | | |

### Example 2 (Bronze process)

An extrusion billet (multicore type billet) was prepared in the same manner as in Example 1, except that instead of winding the Cu sheet, a slit of a Ta sheet having a thickness of 0.2 mm and a width of 20 mm was disposed in 12 places of the inner periphery of the diffusion barrier layer corresponding to the closest filament portion. This extrusion billet was extruded and subjected to wire drawing to form a wire rod (precursor for manufacturing a superconducting wire rod) having a wire diameter of 0.5 mm. No breakage occurred at this wire drawing stage. Also, at the stage after the wire drawing, a distance dB-f between the diffusion barrier layer and the closest filament is 2.5 µm.

The obtained precursor was subjected to a heat treatment (diffusion heat treatment) under the same conditions as in Example 1, thereby forming an Nb₃Sn superconducting wire rod. This superconducting wire rod was measured with respect to the AC loss and critical current density (Jc) in the same manners as in Example 1. As a result, the AC loss was 320 kJ/m³, and the critical current density (Jc) was 770 A/mm².

### Example 3 (Bronze process)

An extrusion billet (multicore type billet) was prepared in the same manner as in Example 1, except that instead of winding the Cu sheet, a slit of a Cu sheet having a thickness of 0.4 mm and a width of 20 mm was disposed in 12 places of the inner periphery of the diffusion barrier layer corresponding to the closest filament portion. This extrusion billet was extruded and subjected to wire drawing to form a wire rod (precursor for manufacturing a superconducting wire rod) having a wire diameter of 0.5 mm. No breakage occurred at this wire drawing stage. Also, at the stage after the wire drawing, a distance dB-f between the diffusion barrier layer and the closest filament is 2.3 µm.

The obtained precursor was subjected to a heat treatment (diffusion heat treatment) under the same conditions as in Example 1, thereby forming an Nb₃Sn superconducting wire rod. This superconducting wire rod was measured with respect to the AC loss and critical current density (Jc) in the same manners as in Example 1. As a result, the AC loss was 675 kJ/m³, and the critical current density (Jc) was 765 A/mm².

### Example 4 (Internal diffusion process)

An Nb rod having a diameter of 18 mm was inserted in a Cu pipe having an outer diameter of 21 mm and an inner diameter of 18 mm and finished into a Cu/Nb composite rod having a hexagonal cross-sectional shape (opposite side of the hexagon: 2.0 mm) by die wire drawing, followed by cutting in a length of 400 mm. This Cu/Nb composite rod was bundled in the number of 336 in a Cu tube having an outer diameter of 143 mm and an inner diameter of 124 mm and disposed centering on a Cu internal cylinder (outer diameter: 70 mm, inner diameter: 61 mm), followed by putting a lid by electron beam welding to form an extrusion billet.

The thus obtained extrusion billet was subjected to pipe extrusion and pipe drawing, and an Sn rod having an outer diameter of 10 mm was then inserted in the center, thereby preparing a monoelement wire rod having a hexagonal cross-sectional shape (opposite side of the hexagon: 3.5 mm). This monoelement wire rod was bundled in the number of 19; an Nb sheet having a thickness of 0.1 mm was disposed on the outer periphery, and a Cu sheet as shown in the following Table 2 was disposed in the inside thereof; and the resultant was disposed in a Cu pipe having an outer diameter of 33 mm and an inner diameter of 26 mm and further subjected to wire drawing to form a wire rod (multielement wire rod) having a final wire diameter of 2.0 mm.

As to the obtained precursors for manufacturing a superconducting wire rod (one having an outer diameter of 2.0 mm), the distance dB-f between the outermost layer filament and the diffusion barrier layer and the number of breakages at the time of extrusion and wire drawing were examined. Also, when each of the precursors was subjected to a heat treatment (diffusion heat treatment) (at 500 °C for 100 hours and at 650 °C for 100 hours) to form an Nb₃Sn superconducting wire rod, the AC loss and the critical current density (Jc) were measured under the same conditions as in Example 1.

These results are summarized and shown in the following Table 2. As is clear from these results, it is noted that in the samples in which the foregoing distance dB-f was made appropriate by mediating the Cu sheet between the diffusion barrier layer and the Nb-based filament (Test Nos. 16 to 21), the AC loss is reduced, and an excellent critical current density Jc can be realized.

**Table 2**

| Test No. | Number of turns of Cu sheet (time) (Thickness of Cu sheet) | Number of breakages (time) | Distance dB-f (µm) | AC loss (kJ/m³) | Critical current density Jc A/mm²) |
|---|---|---|---|---|---|
| 15 | 0 | 5 | 1.5 | 2110 | 955 |
| 16 | 1 (0.05mm) | 1 | 2.0 | 1100 | 935 |
| 17 | 1 (0.15 mm) | 0 | 4.0 | 993 | 927 |
| 18 | 3 (0.13mm) | 0 | 9.0 | 985 | 922 |
| 19 | 5 (0.1 mm) | 0 | 22 | 680 | 910 |
| 20 | 4 (0.2 mm) | 0 | 31 | 650 | 850 |
| 21 | 5 (0.2 mm) | 0 | 40 | 630 | 832 |
| 22 | 7 (0.2 mm) | 1 | 52 | 530 | 755 |

While the invention has been described in detail and with reference to specific embodiments thereof, it will be apparent to one skilled in the art that various changes and modifications can be made therein without departing from the spirit and scope thereof.

This application is based on a Japanese patent application, filed February 23, 2006 (Japanese Patent Application No. 2006-046742), and the contents thereof are incorporated therein by reference.

Also, all references as cited herein are incorporated as a whole.

### INDUSTRIAL APPLICABILITY

According to the invention, by regulating the distance between the inner peripheral surface of the diffusion barrier layer and the Nb-based filament present in the outermost layer part of the superconducting core part at 2 µm or more, the constitution of a precursor for the manufacturing an Nb₃Sn superconducting wire rod which devises to reduce an AC loss to be caused due to coupling and is able to exhibit excellent superconducting property has been able to be realized. Also, as specific means for regulating the foregoing distance at 2 µm or more, by not basically using Ta or disposing Ta only in a necessary place, excellent workability can be realized while devising to reduce costs.

## Claims

1. A precursor for manufacturing an Nb₃Sn superconducting wire rod which is used in manufacturing an Nb₃Sn superconducting wire rod, said precursor comprising:
a superconducting core part comprising a Cu-Sn-based alloy and a plurality of Nb-based filaments composed of Nb or an Nb-based alloy, said plurality of Nb-based filaments being disposed in the Cu-Sn-based alloy;
a diffusion barrier layer which is composed of Nb and is disposed on an outer periphery of the superconducting core part; and
a stabilization copper layer,
wherein a distance between an inner peripheral surface of the diffusion barrier layer and the Nb-based filament present at an outermost layer part of the superconducting core part is set up at 2 µm or more in a final shape after cross section reduction processing.

2. The precursor for manufacturing an Nb₃Sn superconducting wire rod according to claim 1, wherein the distance between the inner peripheral surface of the diffusion barrier layer and the Nb-based filament present in the outermost layer part of the superconducting core part is 10 µm or less.

3. A precursor for manufacturing an Nb₃Sn superconducting wire rod which is used in manufacturing an Nb₃Sn superconducting wire rod, said precursor comprising:
a superconducting core part comprising Cu or a Cu-based alloy, a single or a plurality of Nb-based filaments composed of Nb or an Nb-based alloy and a single or a plurality of Sn or Sn-based alloy cores, said single or plurality of Nb-based filaments and said single or plurality of Sn or Sn-based alloy cores being disposed in Cu or the Cu-based alloy;
a diffusion barrier layer which is composed of Nb and is disposed on an outer periphery of the superconducting core part; and
a stabilization copper layer,
wherein a distance between an inner peripheral surface of the diffusion barrier layer and the Nb-based filament present at an outermost layer part of the superconducting core part is set up at 2 µm or more in a final shape after cross section reduction processing.

4. The precursor for manufacturing an Nb₃Sn superconducting wire rod according to claim 3, wherein the distance between the inner peripheral surface of the diffusion barrier layer and the Nb-based filament present at the outermost layer part of the superconducting core part is 40 µm or less.

5. The precursor for manufacturing an Nb₃Sn superconducting wire rod according to any one of claims 1 to 4, said precursor comprising a layer which is composed of Cu or a Cu-based alloy and is disposed on an entire surface of the inner periphery of the diffusion barrier layer, wherein said distance is regulated at 2 µm or more.

6. The precursor for manufacturing an Nb₃Sn superconducting wire rod according to any one of claims 1 to 5, said precursor comprising a layer which is composed of Ta, Cu or a Cu-based alloy and is disposed at a position on the inner peripheral surface of the diffusion barrier layer where the Nb-based filament is adjacent to the diffusion barrier layer, wherein said distance is regulated at 2 µm or more.

7. The precursor for manufacturing an Nb₃Sn superconducting wire rod according to any one of claims 1 to 6, wherein the Nb-based filament has a diameter of 1.5 to 6.0 µm in a final shape after cross section reduction processing.

8. An Nb₃Sn superconducting wire rod, which is obtained by subjecting the precursor for manufacturing an Nb₃Sn superconducting wire rod according to any one of claims 1 to 7 to an Nb₃Sn forming heat treatment to thereby form an Nb₃Sn based superconducting phase.

## Patentansprüche

1. Vorläufer zur Herstellung eines supraleitenden Nb₃Sn Drahtstabs, welcher in der Herstellung eines supraleitenden Nb₃Sn Drahtstabs verwendet wird, wobei der Vorläufer umfaßt:
einen supraleitenden Kernteil, umfassend eine Cu-Sn-basierende Legierung und eine Vielzahl von Nb-basierenden Filamenten, aufgebaut aus Nb oder einer Nb-basierenden Legierung, wobei die Vielzahl von Nb-basierenden Filamenten in der Cu-Sn-basierenden Legierung angeordnet sind,
eine Diffusionssperrschicht, welche aus Nb aufgebaut ist und auf einer äußeren Peripherie des supraleitenden Kernteils angeordnet ist, und
eine Stabilisationskupferschicht, wobei ein Abstand zwischen einer inneren peripheren Oberfläche der Diffusionssperrschicht und dem Nb-basierenden Filament, vorliegend an einem äußersten Schichtteil des supraleitenden Kernteils,
auf 2 µm oder mehr in einer finalen Form nach Querschnittverminderungsverarbeiten eingestellt ist.

2. Vorläufer zum Herstellen eines supraleitenden Nb₃Sn Drahtstabs gemäß Anspruch 1, wobei der Abstand zwischen der inneren peripheren Oberfläche der Diffusionssperrschicht und dem Nb-basierenden Filament, vorliegend in dem äußersten Schichtteil des supraleitenden Kernteils, 10 µm oder weniger beträgt.

3. Vorläufer zum Herstellen eines supraleitenden Nb₃Sn Drahtstabs, welcher in der Herstellung eines supraleitenden Nb₃Sn Drahtstabs verwendet wird, wobei der Vorläufer umfaßt:
einen supraleitenden Kernteil, umfassend Cu oder eine Cu-basierende Legierung, ein einzelnes oder eine Vielzahl von Nb-basierenden Filamenten, aufgebaut aus Nb oder einer Nb-basierenden Legierung, und ein einzelner oder eine Vielzahl von Kernen von Sn oder Sn-basierender Legierung, wobei das einzelne oder die Vielzahl von Nb-basierenden Filamenten und der einzelne oder die Vielzahl von Kernen von Sn oder Sn-basierender Legierung in Cu oder der Cu-basierenden Legierung angeordnet sind,
eine Diffusionssperrschicht, welche aus Nb aufgebaut ist und auf einer äußeren Peripherie des supraleitenden Kernteils angeordnet ist, und
eine Stabilisationskupferschicht, wobei ein Abstand zwischen einer inneren peripheren Oberfläche der Diffusionssperrschicht und dem Nb-basierenden Filament, vorliegend an einem äußersten Schichtteil des supraleitenden Kernteils,
auf 2 µm oder mehr in einer finalen Form nach Querschnittsverminderungsverarbeitend eingestellt ist.

4. Vorläufer zum Herstellen eines supraleitenden Nb₃Sn Drahtstabs gemäß Anspruch 3, wobei der Abstand zwischen der inneren peripheren Oberfläche der Diffusionssperrschicht und dem Nb-basierenden Filament, vorliegend an dem äußersten Schichtteil des supraleitenden Kernteils, 40 µm oder weniger beträgt.

5. Vorläufer zum Herstellen eines supraleitenden Nb₃Sn Drahtstabs gemäß einem der Ansprüche 1 bis 4, wobei der Vorläufer eine Schicht umfaßt, welche aus Cu oder einer Cu-basierenden Legierung aufgebaut ist und auf einer gesamten Oberfläche der inneren Peripherie der Diffusionssperrschicht angeordnet ist, wobei der Abstand auf 2 µm oder mehr reguliert ist.

6. Vorläufer zum Herstellen eines supraleitenden Nb₃Sn Drahtstabs gemäß einem der Ansprüche 1 bis 5, wobei der Vorläufer eine Schicht umfaßt, welche aus Ta, Cu oder einer Cu-basierende Legierung aufgebaut ist und an einer Position auf der inneren peripheren Oberfläche der Diffusionssperrschicht angeordnet ist, wobei das Nb-basierende Filament an die Diffusionsperrschicht angrenzend ist, wobei der Abstand auf 2 µm oder mehr reguliert ist.

7. Vorläufer zum Herstellen eines supraleitenden Nb₃Sn Drahtstabs gemäß einem der Ansprüche 1 bis 6, wobei das Nb-basierende Filament einen Durchmesser von 1,5 bis 6,0 µm in einer finalen Form nach Querschnittsverminderungsverarbeiten aufweist.

8. Supraleitender Nb₃Sn Drahtstab, welcher durch Unterwerfen des Vorläufers zum Herstellen eines supraleitenden Nb₃Sn Drahtstabs gemäß einem der Ansprüche 1 bis 7 einer Nb₃Sn bildenden Wärmebehandlung erhalten wird, wodurch eine Nb₃Sn-basierende supraleitende Phase gebildet wird.

## Revendications

1. Précurseur de fabrication d'un fil machine supraconducteur en Nb₃Sn qui est utilisé dans la fabrication d'un fil machine supraconducteur en Nb₃Sn, ledit précurseur comprenant :
une partie d'âme supraconductrice comprenant un alliage à base de Cu-Sn et une pluralité de filaments à base de Nb composés de Nb ou d'un alliage à base de Nb, ladite pluralité de filaments à base de Nb étant disposée dans l'alliage à base de Cu-Sn ;
une couche de barrière à la diffusion qui est composée de Nb et est disposée sur une périphérie externe de la partie d'âme supraconductrice ; et
une couche de cuivre de stabilisation,
dans lequel une distance entre une surface périphérique interne de la couche de barrière à la diffusion et le filament à base de Nb présent au niveau d'une partie de couche la plus externe de la partie d'âme supraconductrice est fixée à 2 µm ou plus dans une forme finale après traitement de réduction de la section.

2. Précurseur de fabrication d'un fil machine supraconducteur en Nb₃Sn selon la revendication 1, dans lequel la distance entre la surface périphérique interne de la couche de barrière à la diffusion et le filament à base de Nb présent dans la partie de couche la plus externe de la partie d'âme supraconductrice est de 10 µm ou moins.

3. Précurseur de fabrication d'un fil machine supraconducteur en Nb₃Sn qui est utilisé dans la fabrication d'un fil machine supraconducteur en Nb₃Sn, ledit précurseur comprenant :
une partie d'âme supraconductrice comprenant du Cu ou un alliage à base de Cu, un seul ou une pluralité de filaments à base de Nb composés de Nb ou d'un alliage à base de Nb, et un seul ou une pluralité d'âmes de Sn ou d'alliage à base de Sn, ledit seul ou ladite pluralité de filaments à base de Nb et ledit seul ou ladite pluralité d'âmes de Sn ou d'alliage à base de Sn étant disposés dans le Cu ou l'alliage à base de Cu ;
une couche de barrière à la diffusion qui est composée de Nb et est disposée sur une périphérie externe de la partie d'âme supraconductrice ; et
une couche de cuivre de stabilisation,
dans lequel une distance entre une surface périphérique interne de la couche de barrière à la diffusion et le filament à base de Nb présent au niveau d'une partie de couche la plus externe de la partie d'âme supraconductrice est fixée à 2 µm ou plus dans une forme finale après traitement de réduction de la section.

4. Précurseur de fabrication d'un fil machine supraconducteur en Nb₃Sn selon la revendication 3, dans lequel la distance entre la surface périphérique interne de la couche de barrière à la diffusion et le filament à base de Nb présent dans la partie de couche la plus externe de la partie d'âme supraconductrice est de 40 µm ou moins.

5. Précurseur de fabrication d'un fil machine supraconducteur en Nb₃Sn selon l'une quelconque des revendications 1 à 4, dans lequel ledit précurseur comprend une couche qui est composée de Cu ou d'un alliage à base de Cu et est disposée sur une surface entière de la périphérie interne de la couche de barrière à la diffusion, dans lequel ladite distance est régulée à 2 µm ou plus.

6. Précurseur de fabrication d'un fil machine supraconducteur en Nb₃Sn selon l'une quelconque des revendications 1 à 5, dans lequel ledit précurseur comprend une couche qui est composée de Ta, Cu ou un alliage à base de Cu et est disposée en une position sur la surface périphérique interne de la couche de barrière à la diffusion où le filament à base de Nb est adjacent à la couche de barrière à la diffusion, dans lequel ladite distance est régulée à 2 µm ou plus.

7. Précurseur de fabrication d'un fil machine supraconducteur en Nb₃Sn selon l'une quelconque des revendications 1 à 6, dans lequel le filament à base de Nb a un diamètre de 1,5 à 6,0 µm dans une forme finale après traitement de réduction de la section.

8. Fil machine supraconducteur en Nb₃Sn, qui est obtenu en soumettant le précurseur de fabrication d'un fil machine supraconducteur en Nb₃Sn selon l'une quelconque des revendications 1 à 7 à un traitement thermique de formation de Nb₃Sn pour former ainsi une phase supraconductrice à base de Nb₃Sn.
